(19) Europäisches Patentamt
European Patent Office
Office européen des brevets

(11) **EP 1 768 139 B1**

(12) **EUROPÄISCHE PATENTSCHRIFT**

(45) Veröffentlichungstag und Bekanntmachung des Hinweises auf die Patenterteilung:
**21.05.2008 Patentblatt 2008/21**

(51) Int Cl.:
*H01G 5/14* (2006.01)     *G01R 33/00* (2006.01)

(21) Anmeldenummer: **06019424.8**

(22) Anmeldetag: **16.09.2006**

(54) **Rohrkondensator mit variabler Kapazität mit dielektrisch verlängerter Innenelektrode für NMR-Anwendungen**

Cylindrical capacitor with variable capacity and a dielectric extension of the inner electrode for NMR applications

Capacité cylindrique variable avec un prolongement diélectrique de l' électrode interne pour applications RMN

(84) Benannte Vertragsstaaten:
**CH DE FR GB LI**

(30) Priorität: **27.09.2005 DE 102005046039**

(43) Veröffentlichungstag der Anmeldung:
**28.03.2007 Patentblatt 2007/13**

(73) Patentinhaber: **Bruker BioSpin AG**
**8117 Fällanden (CH)**

(72) Erfinder:
• **Grossniklaus, Beat**
**8173 Riedt (CH)**
• **Marek, Daniel**
**5103 Möriken (CH)**
• **Seydoux, Roberto**
**8610 Uster (CH)**
• **Schett, Oskar**
**8610 Uster (CH)**

(74) Vertreter: **Kohler Schmid Möbus**
**Patentanwälte**
**Ruppmannstrasse 27**
**70565 Stuttgart (DE)**

(56) Entgegenhaltungen:
**EP-A- 1 329 916**     **FR-A- 2 886 450**

**Beschreibung**

Die Erfindung betrifft einen Rohrkondensator mit variabler Kapazität, umfassend ein zylinderförmiges Rohr aus dielektrischem Material, eine metallische Außenelektrode, die das zylinderförmige Rohr umgibt, und eine Innenelektrode, die in der Innenbohrung des zylinderförmigen Rohrs axial beweglich ist und in der Innenbohrung anliegt, wobei die Innenelektrode einen metallischen Stab umfasst.

Rohrkondensatoren diesen Typs wurden zum Beispiel eingesetzt in NMR-Spektroskopie-Systemen, wie sie in dem Firmenprospekt "Avance - The Pulse Of Innovation" der Firma Bruker Biospin AG, Fällanden, Schweiz, April 2004, beschrieben werden. Ein solcher Rohrkondensator wird auch in EP 1 329 916 beschrieben.

Kernspinresonanz(=NMR)-Spektrometrie ist eines der leistungsfähigsten Verfahren der instrumentellen Analytik und wird insbesondere in den Biowissenschaften und in der Materialforschung angewandt. Dabei werden mit einem Hochfrequenz(=HF)-Resonator HF-Feldimpulse in eine Probe eingestrahlt, und die Reaktion der Probe wird gemessen und ausgewertet.

Qualitativ hochwertige NMR-Spektren erhält man mit möglichst kurzen eingestrahlten HF-Feldimpulsen. Die erreichbare Kürze hängt davon ab, wie hoch die HF-Feldamplitude eingestellt werden kann, ohne dass Hochspannungsüberschläge im HF-Resonator und insbesondere auch in den kapazitiven Abstimmelementen des HF-Resonators auftreten. Daher begrenzt die Hochspannungsfestigkeit (oder Durchschlagfestigkeit) der kapazitiven Abstimmelemente die Qualität der erhaltenen NMR-Spektren. Als kapazitive Abstimmelemente werden im Stand der Technik Rohrkondensatoren mit variabler Kapazität eingesetzt, wie sie eingangs beschrieben wurden.

Aufgabe der Erfindung

Es ist daher die Aufgabe der vorliegenden Erfindung, die Durchschlagfestigkeit von Rohrkondensatoren mit variabler Kapazität zu erhöhen, insbesondere um mit diesen Rohrkondensatoren NMR-Spektrometer mit einer verbesserten Auflösung bereitzustellen.

Kurze Beschreibung der Erfindung

Diese Aufgabe wird gelöst durch einen Rohrkondensator der eingangs vorgestellten Art, der dadurch gekennzeichnet ist, dass der metallische Stab an seinem Ende, das sich in der Innenbohrung des zylinderförmigen Rohres befindet, durch einen Stab aus dielektrischem Material in axialer Richtung verlängert ist.

Im Rahmen der Erfindung wurde festgestellt, dass es zu Hochspannungsüberschlägen im Rohrkondensator des Standes der Technik nicht etwa im Bereich des schmalen Spaltes zwischen zylinderförmigem Rohr aus dielektrischem Material und anliegendem metallischem Stab der Innenelektrode kommt, sondern im Bereich des Endes des metallischen Stabes. Der Hochspannungsüberschlag tritt also überraschender Weise dort auf, wo relativ viel Abstand und Luft die Elektroden trennt. Dies gilt auch dann, wenn der metallische Stab ein abgerundetes Abschlussteil besitzt.

Im erfindungsgemäßen Rohrkondensator wird die Durchschlagfestigkeit dadurch erhöht, dass in dem Bereich des Rohrkondensators, in dem Hochspannungsüberschläge besonders stark drohen, die wenig durchschlagfeste Luft ersetzt wird durch ein festes, elektrisch isolierendes, dielektrisches Material, welches verglichen mit Luft oder anderen Gasen eine sehr viel höhere Durchschlagfestigkeit aufweist (Faktor 10 oder besser gegenüber Luft). Durch die Befestigung eines Stabes aus dielektrischem Material am durchschlaggefährdeten Ende des metallischen Stabes ist das dielektrische Material auch stets richtig positioniert. Als dielektrisches Stabmaterial stehen beispielsweise Kunststoff, insbesondere Teflon, Glas oder auch keramische Materialien, insbesondere Aluminiumoxid, zur Verfügung.

Bevorzugt ist eine Ausführungsform des erfindungsgemäßen Rohrkondensators, bei der der Stab aus dielektrischem Material im Verbindungsbereich zu dem metallischen Stab den gleichen Außendurchmesser besitzt wie der metallische Stab. Der Stab aus dielektrischem Material braucht nicht einen konstanten Außendurchmesser über seine gesamte Länge aufzuweisen. An der ringförmigen Übergangslinie zwischen metallischem Stab und Stab aus dielektrischem Material an der Außenseite der Stäbe sollte jedoch der Außendurchmesser der Stäbe gleich sein. Dadurch wird eine hohe Durchschlagfestigkeit erreicht. Stäbe und Bohrung sind im Querschnitt bevorzugt kreisrund oder elliptisch ausgebildet. Im Falle nicht-kreisrunder (insbesondere eckiger) Querschnitte tritt die Außenlinie des Querschnittes eines Stabes an die Stelle des Außendurchmessers.

Eine bevorzugte Weiterbildung dieser Ausführungsform ist dadurch gekennzeichnet, dass der Stab aus dielektrischem Material in einem sich dem metallischen Stab unmittelbar anschließenden Längenbereich, insbesondere über seine gesamte Länge, den gleichen Außendurchmesser besitzt wie der metallische Stab. Dieser sich unmittelbar anschließende Längenbereich entspricht bevorzugt wenigstens dem 1,5-fachen des Durchmessers des metallischen Stabes zuzüglich der axialen Ausdehnung eines Abschlussteils des metallischen Stabes, das in aller Regel verwendet wird.

Auch dies stellt eine hohe Durchschlagfestigkeit des Rohrkondensators sicher, indem größere Luftspalte in der Nähe des Endes des metallischen Stabes vermieden werden.

Ganz besonders bevorzugt ist eine Ausführungsform des erfindungsgemäßen Rohrkondensators, die vorsieht, dass der metallische Stab am seinem Ende, das sich in der Innenbohrung des zylinderförmigen Rohres befindet, ein abgerundetes Abschlussteil besitzt, insbesondere derart, dass keine kantenförmigen Übergänge am diesem Ende des metallischen Stabes vorhanden sind. Das Abschlussteil des metallischen Stabes beginnt dort, wo der metallische Stab im Bereich seines in der Bohrung des dielektrischen Rohres liegenden Endes von der zylinderförmigen Gestalt abweicht, d.h. der Durchmesser sich verkleinert. Das abgerundete Abschlussteil und metallischer Stab sind regelmäßig einstückig ausgebildet. Das abgerundete Abschlussteil reduziert die Feldstärke in der Umgebung des Endes des metallischen Stabes und verringert so die Neigung zu Hochspannungsüberschlägen.

Bei einer bevorzugten Weiterbildung dieser Ausführungsform beträgt die Länge $L_D$ des Stabes aus dielektrischem Material mindestens die Summe aus der axialen Ausdehnung $L_A$ des Abschlussteils und dem 1,5-fachen Durchmesser $D_M$ des metallischen Stabes. D.h. es gilt $L_D \geq L_A + 1{,}5\,D_M$. Damit deckt der Stab aus dielektrischem Material den besonders überschlagsgefährdeten Bereich am Ende des metallischen Stabes ab, wodurch eine verbesserte Durchschlagfestigkeit erreicht wird.

Bevorzugt ist weiterhin eine Weiterbildung, bei der das Abschlussteil des metallischen Stabes mindestens eine zylinderförmige Stufe aufweist. Als zylinderförmige Stufe wird ein Längenabschnitt (oder Plateaubereich) des Abschlussteils verstanden, in dem der Außendurchmesser über eine nicht verschwindende Länge konstant (aber kleiner als der Durchmesser des metallischen Stabes in seinem zylindrischen, vom Abschlussteil entfernten Bereich) ist. Damit kann die dielektrische Verlängerung (d.h. der Stab aus dielektrischem Material) mechanisch stabiler mit dem metallischen Stab verbunden werden.

Bevorzugt ist auch eine Weiterbildung, bei der das Abschlussteil des metallischen Stabes mindestens eine Einschnürung aufweist. Damit wird die mechanische Verankerung der dielektrischen Verlängerung mit dem metallischen Stab noch stabiler und robuster. Durch die Einschnürung kann insbesondere eine elastisch herstell- und lösbare, klemmende Befestigung realisiert werden.

Besonders vorteilhaft ist eine Weiterbildung der obigen Ausführungsform, bei der das Abschlussteil des metallischen Stabes näherungsweise die Form eines lang gezogenen Rotationsellipsoides aufweist. Diese Form führt zu den kleinsten Feldspitzen, insbesondere wegen der sanften und stetigen Verkleinerung des Außendurchmessers des metallischen Stabes, und daher zu besten Durchschlagfestigkeiten.

Ganz besonders bevorzugt ist noch eine Weiterbildung, die vorsieht, dass der Stab aus dielektrischem Material mit der gesamten Oberfläche des Abschlussteils dicht, insbesondere ohne Lufteinschlüsse, verbunden ist. Mit anderen Worten, Abschlussteil und Stab aus dielektrischem Material haben einen vollflächigen Kontakt. Dies verbessert wiederum die Durchschlagfestigkeit an der Verbindungsfläche.

Vorteilhaft ist weiterhin eine Ausführungsform des erfindungsgemäßen Rohrkondensators, bei der das dielektrische Material des zylinderförmigen Rohres und das dielektrische Material des Stabes relative Dielektrizitätskonstanten zwischen 1,3 und 5 aufweisen, insbesondere wobei das dielektrische Material jeweils Teflon ist. Solches Material ist gut zur Verhinderung von Hochspannungsüberschlägen geeignet.

Weiterhin bevorzugt ist eine Ausführungsform, bei der sich die relativen Dielektrizitätskonstanten des dielektrischen Materials des zylinderförmigen Rohres und des Stabes um 1,0 oder weniger unterscheiden, insbesondere wobei die beiden relativen Dielektrizitätskonstanten identisch sind. Auch dadurch wird die Neigung zu Hochspannungsüberschlägen reduziert.

In den Rahmen der vorliegenden Erfindung fällt auch ein Kernspinresonanz (=NMR)-Probenkopf, umfassend einen Hochfrequenz(=HF)-Resonator und eine Schaltung zum Betrieb des HF-Resonators, dadurch gekennzeichnet, dass die Schaltung mindestens einen erfindungsgemäßen Rohrkondensator umfasst. Ein solcher Probenkopf weist eine verbesserte Durchschlagfestigkeit auf, so dass auch sehr kurze, starke HF-Impulse mit dem HF-Resonator in eine Probe eingestrahlt werden können, und mit dem zugehörigen NMR-Spektrometer können Spektren verbesserter Qualität gemessen werden.

Weitere Vorteile der Erfindung ergeben sich aus der Beschreibung und den Zeichnungen. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung näher dargestellt und erläutert. Es zeigt:

Fig. 1      ein Diagramm des zeitlichen Verlaufs (t) eines Stromes ($i_L$) in einem HF-Resonator während eines HF-Impulses;

Fig. 2a    eine Schaltung eines typischen HF-Resonators eines Probenkopfes für ein NMR-Spektrometer; als abstimmbare Kapazitäten $C_T$ und $C_M$ können erfindungsgemäße Rohrkondensatoren eingesetzt werden;

Fig. 2b    ein Ersatzschaltbild der Schaltung von Fig. 2a im abgestimmten Fall;

Fig. 3a    ein Diagramm der relativen Amplitude der Spannung U am Punkt A der Schaltung von Fig. 2a als Funktion der Senderfrequenz f;

Fig. 3b    ein Diagramm der relativen Phase der Spannung U am Punkt A der Schaltung von Fig. 2a als Funktion der Senderfrequenz f;

Fig. 3c    ein Diagramm der relativen Amplitude der Spannung U am Punkt B der Schaltung von Fig. 2a als Funktion der Senderfrequenz f;

Fig. 3d    ein Diagramm der relativen Phase der Spannung U am Punkt B der Schaltung von Fig. 2a als Funktion der Senderfrequenz f;

Fig. 4    eine schematische Darstellung eines Rohrkondensators mit variabler Kapazität nach dem Stand der Technik;

Fig. 5    einen vergrößerten Ausschnitt aus Fig. 4 im Bereich des Endes des metallischen Stabes, wobei der metallische Stab gegenüber der Position von Fig. 4 verschoben ist;

Fig. 6a    eine schematische Darstellung eines Rohrkondensators mit variabler Kapazität gemäß der Erfindung;

Fig. 6b    einen vergrößerten Ausschnitt aus Fig. 6 im Bereich des Endes des metallischen Stabes, wobei der metallische Stab gegenüber der Position von Fig. 6a geringfügig verschoben ist;

Fig. 7    eine schematische Darstellung eines Ausschnitts aus einem Rohrkondensator mit variabler Kapazität gemäß der Erfindung mit zwei zylinderförmigen Stufen im abgerundeten Abschlussteil des metallischen Stabes;

Fig. 8    eine schematische Darstellung eines Ausschnitts aus einem Rohrkondensator mit variabler Kapazität gemäß der Erfindung mit einer Einschnürung im abgerundeten Abschlussteil des metallischen Stabes;

Fig. 9    eine schematische Darstellung eines Ausschnitts aus einem Rohrkondensator mit variabler Kapazität gemäß der Erfindung mit einem abgerundeten Abschlussteil in Form eines langgestreckten Rotationsellipsoids;

Fig. 10    ein Diagramm der Durchschlagsfeldstärke $E_D$ im Luftspalt zweier planarer Elektroden, aufgetragen gegen die Breite $d_L$ des Luftspalts;

Fig. 11    ein Diagramm des radialen elektrischen Feldes im Luftspalt im Bereich des Endes des metallischen Stabes in einem Rohrkondensator entsprechend Fig. 9, bei verschiedenen Halbachsenverhältnissen des Rotationsellipsoids;

Fig. 12    ein Diagramm des axialen elektrischen Feldes im Luftspalt im Bereich des Endes des metallischen Stabes in einem Rohrkondensator entsprechend Fig. 9, bei verschiedenen Halbachsenverhältnissen des Rotationsellipsoids.

*1. Einführung*

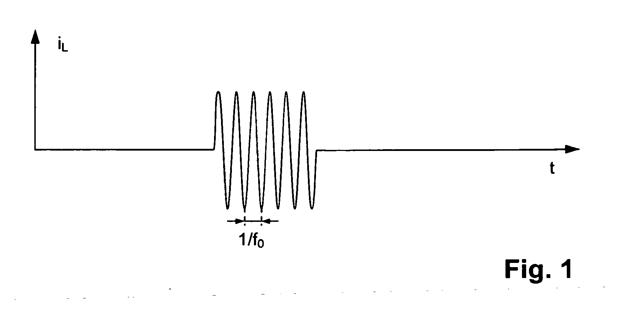

Heutige NMR-Spektrometer benutzen fast ausschließlich kurze HF-Impulse oder genau definierte Gruppen von HF-Impulsen, um die magnetischen Spins in der Messprobe anzuregen. Das daraus resultierende Signal nennt man das FID (**F**ree **I**nduction **D**ecay), aus dem dann anschließend mit Hilfe einer schnellen Fouriertransformation das gewünschte NMR-Spektrum rechnerisch ermittelt wird.
Die Anregung der Messprobe erfolgt mit Hilfe eines HF-Resonators (HF = Hochfrequenz), der sich innerhalb des NMR-Probenkopfes befindet, dicht um die Messprobe angeordnet und auf die gewünschte Anregungsfrequenz $f_0$ abgestimmt ist. Die Anregungsfrequenz für Protonen liegt bei heutigen NMR-Spektrometern zwischen 100 MHz und 900 MHz.
Während des Anregungsvorganges werden kurze HF-Stromimpulse $i_L$ (siehe **Fig.1**) in den HF-Resonator eingespeist, wodurch kurze, magnetische HF-Feldimpulse entstehen, mit denen das Spinsystem angeregt wird.
Die HF-Feldimpulse müssen einerseits möglichst kurz sein, damit das ganze NMR-Spektrum gleichzeitig und so gleichmäßig wie möglich angeregt wird, und anderseits eine genügend hohe HF-Feldamplitude besitzen, damit die Rotationsachse der Spins vorzugsweise um einen Flip-Winkel von ca. 90° gedreht wird. Die 90° garantieren im Allgemeinen die beste Empfindlichkeit, d.h. das beste Signal-zu-Rausch-Verhältnis (SINO) für das empfangene NMR-Signal.

Wie kurz die HF-Feldimpulse sein dürfen hängt davon ab, wie hoch die HF-Feldamplitude eingestellt werden kann, ohne dass es zu Hochspannungsüberschlägen im HF-Resonator oder in seinen kapazitiven Abstimmelementen kommt. Bei den heutigen NMR-Spektrometern werden im HF-Resonator HF-Leistungen von bis zu 1 kW eingespeist!

Nun ist es aber so, dass die Überschläge nicht unbedingt im HF-Resonator selbst, sondern oft in den kapazitiven Abstimmelementen entstehen. Es ist deshalb bei den Herstellern von NMR-Spektrometern ein dringliches Bedürfnis vorhanden, die Hochspannungsfestigkeit solcher kapazitiven Abstimmelemente so weit wie möglich zu verbessern.

Die HF-Impulse zur Anregung des Spinsystems werden von einem HF-Sender über eine HF-Leitung, die vorzugsweise einen Wellenwiderstand von 50 Ω besitzt, dem HF-Resonator zugeführt.

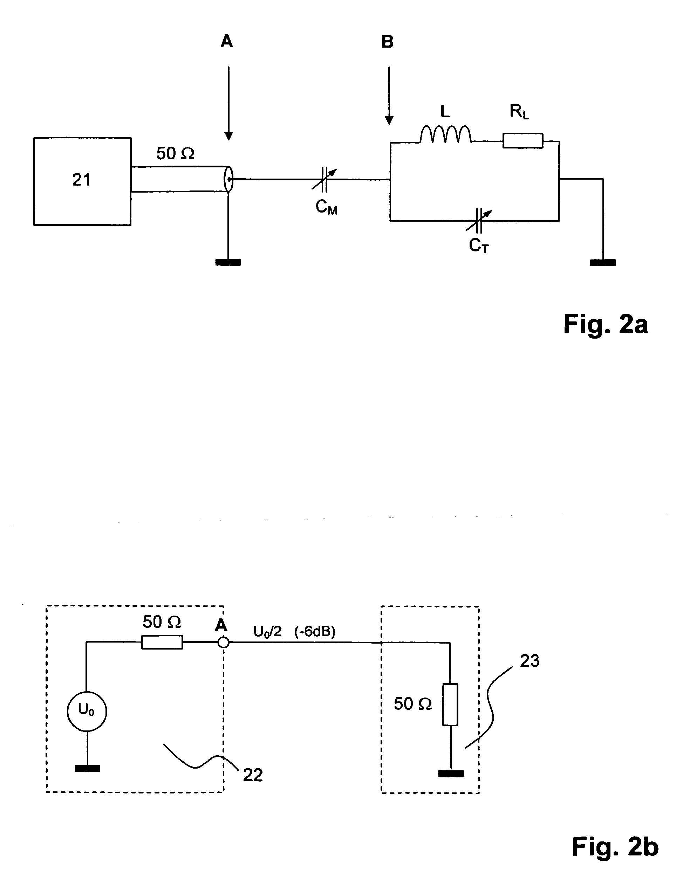

**Fig. 2a** zeigt eine typische Schaltung eines HF-Resonators, wie er häufig in der NMR eingesetzt wird. Dabei erzeugt der HF-Sender 21 intern eine sinusförmige Quellenspannung $U_0$ einer Frequenz $f_0$, im vorliegenden Beispiel 600 MHz, welche über einen Seriewiderstand von 50 Ω nach außen geführt wird. Hier spricht man vom Ausgangswiderstand des Senders, und dieser muss zum Wellenwiderstand des HF-Kabels identisch sein, damit reflexionsfrei Energie übertragen werden kann.

Der HF-Resonator wird bei Punkt A (vgl. Fig. 2a) angeschlossen und besteht aus einem Schwingkreis aus L, $C_T$, $C_M$ und $R_L$, wobei $R_L$ der Verlustwiderstand der NMR Spule darstellt. Mit $C_M$ wird die Anpassung an 50 Ω hergestellt (Matching) und mit $C_T$ wird der Kreis auf die korrekte Resonanzfrequenz abgestimmt (Tuning), wobei beide Kapazitäten sich gegenseitig beim Abstimmen beeinflussen. Nach dem Abstimmvorgang verhält sich der HF-Resonator wie ein 50 Ω Widerstand vom Punkt A aus in den HF-Resonator gesehen, so dass die gesamte HF-Energie reflexionsfrei (also zu 100%) in den HF-Resonator gelangt. Die aufgenommene Leistung wird dann im Spulenverlustwiderstand $R_L$ freigesetzt, d.h. die NMR Spule erhitzt sich und erzeugt dabei ein starkes HF-Feld zur Anregung der Kernspins.

Wird ein zu untersuchendes Lösungsmittel (Messprobe) in das Spuleninnere geführt, dann kann dort noch zusätzlich Energie absorbiert werden. Auch muss unter Umständen der Resonanzkreis spezifisch auf das eingeführte Lösungsmittel wieder auf seine Arbeitsfrequenz abgestimmt werden, da es die elektrische Schaltung verändert und belastet.

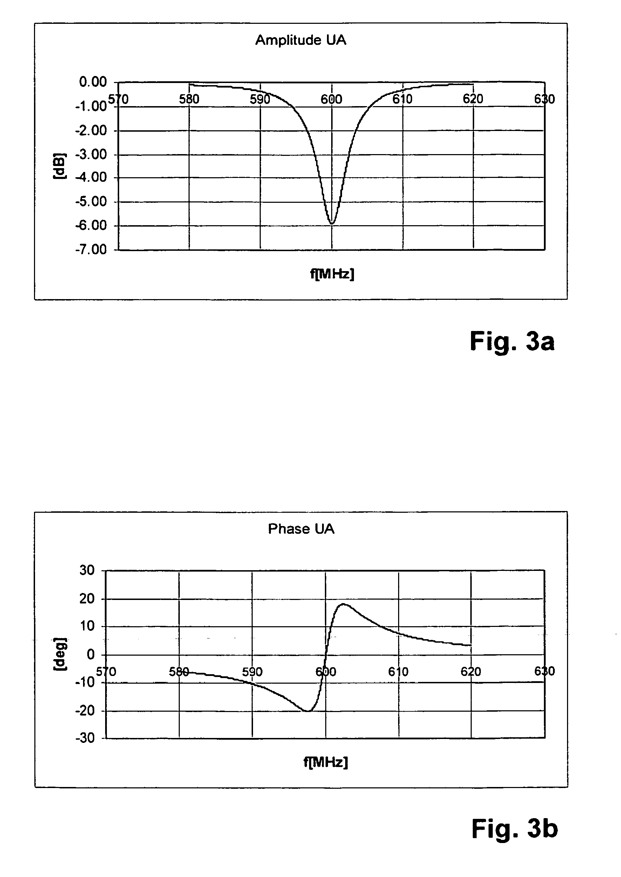

Der Einfachheit halber sei ein ohne Messprobe laufender HF-Resonator in Betracht gezogen, welcher auf 600 MHz reflexionsfrei abgestimmt ist. Korrekt abgestimmt ist dann, wenn der gesamte Resonator sich wie ein 50 Ω Widerstand verhält, d.h. am Punkt A der Schaltung misst man die halbe Quellenspannung ($U_0/2$) des Senders bzw. die Spannung liegt dort bei minus 6dB (**Fig. 3a**) und einer Phasenlage von 0° (**Fig. 3b**). Der Resonator erscheint somit als 50 Ω Seriewiderstand zum Ausgangswiderstand des Senders. **Fig. 2b** zeigt das Ersatzschaltbild des Senders 22 mit dem abgestimmten HF-Resonator 23. Im nicht abgestimmten Fall hat dieses Ersatzschaltbild keine Gültigkeit.

Betrachtet man nun die Spannung über der NMR-Spule an Punkt B (Fig. 2a), so kann diese, abhängig von der Güte der NMR Spule, sehr hohe Werte annehmen. Im folgenden Beispiel wurde die Schaltung gemäss Fig. 2a verwendet mit:

$C_M$ = 0.172 pF

$C_T$ = 0.833 pF

L = 70 nH

$R_L$ = 1.5 Ω

Bei einer Senderausgangsleistung von 300W ergibt dies:

$$P = U_A^2 / R \qquad R = 50\ \Omega$$

d.h. bei Punkt A sieht man eine Spannung von $U_A = \sqrt{(P*R)}$ = 122 Volt und die Quellenspannung $U_0$ des Senders beträgt demnach $2*U_A$ = 245 V. Damit wird die Spannung über der NMR Spule an Punkt B (Fig. 2a) sehr groß, nämlich

$$U_B = 24\text{dB}*U_0 \approx 16*\,U_0 = 3.9\ \text{kV}_{\text{eff}} \quad \text{bzw.} \quad \hat{U}_B = 5.5\ \text{kV} \ \ (\text{Scheitelwert})$$

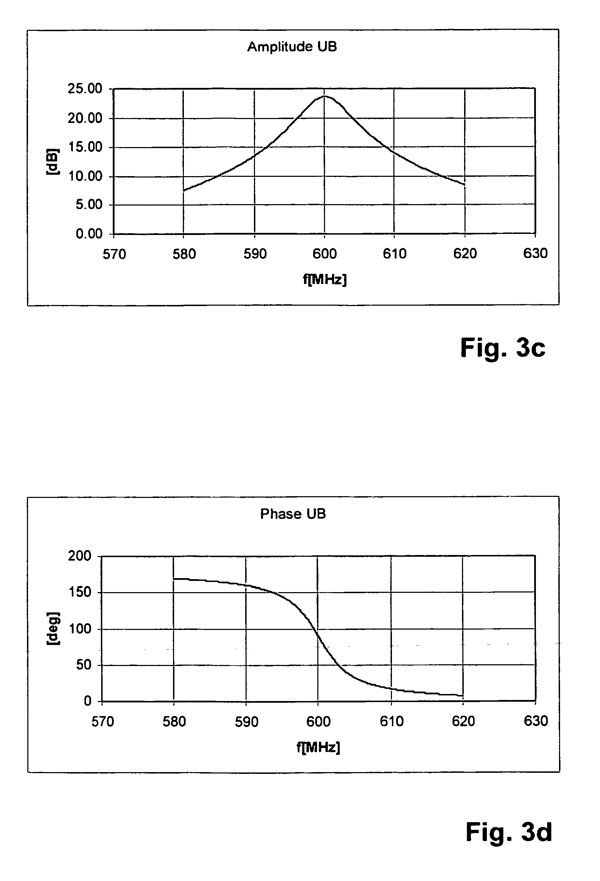

gemäss den berechneten Spannungs- und Phasenverläufen von **Fig. 3c** und **Fig. 3d**. Damit ist gezeigt, dass sehr hohe HF-Spannungen im HF-Resonator auftreten können.

Man beachte aber auch, dass im Spulenkreis nicht nur hohe Spannungen entstehen, sondern auch sehr hohe Ströme. Sie führen schließlich zu einem starken magnetischen Feld für die Anregung der Kernspins.

Die gezeichnete Beispielschaltung kann im weiteren Sinn auch als ein Transformator verstanden werden, welcher den Verlustwiderstand $R_L$ auf 50 Ω hochtransformiert. D.h. der Sender sieht eine Last von 50 Ω, effektiv geht die Energie aber in einen Widerstand, der sehr viel kleiner ist.

*2. Stand der Technik*

Im Allgemeinen werden zur Resonanzabstimmung und Leistungsanpassung des HF-Resonators variable Rohrkondensatoren eingesetzt. Diese müssen möglichst kleine Abmessungen und verschwindend kleine magnetische Suszeptibilitätswerte besitzen und trotzdem sehr hohe HF-Spannungen ertragen können. Kommerziell gesehen handelt es sich hier um ein Nischenprodukt sehr hoher Qualität, das nicht in hohen Mengen produziert werden kann und deshalb für kommerzielle Hersteller von variablen Kapazitäten uninteressant ist. Hersteller von NMR-Spektrometern sind deshalb darauf angewiesen, diese Rohrkondensatoren selber zu entwerfen und herzustellen.

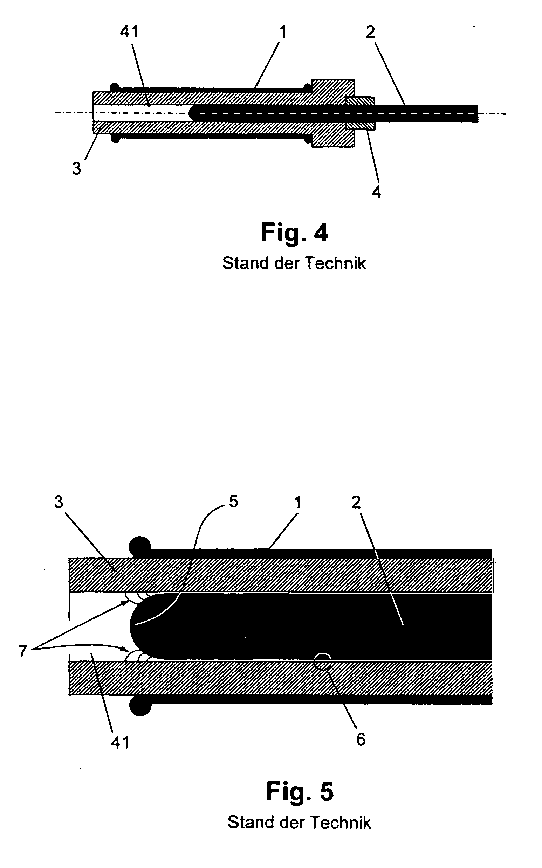

Rohrkondensatoren sind koaxial- und zylinderförmig aufgebaut (**Fig.4**) und bestehen aus einem zylinderförmigen Rohr 3 aus dielektrischem Material, einem außen fest anliegenden Metallrohr als Außenelektrode 1 und eine in der Innenbohrung 41 des zylinderförmigen Rohrs 3 aus dielektrischem Material dicht anliegende, aber axial bewegliche Innenelektrode. Letztere besteht aus einem metallischen Stab 2, der an seinem in der Innenbohrung 41 befindlichen Ende 5' derart abgerundet ist, dass keine kantenförmigen Übergänge vorhanden sind.

Die Kontaktierung der Innenelektrode bzw. des metallischen Stabes 2 erfolgt beispielsweise mit einer metallischen Kontakthülse 4. Für das dielektrische Rohr 3 wird vorzugsweise Teflon verwendet, welches sich durch eine hohe Spannungsfestigkeit und HF-Güte auszeichnet. Der einstellbare Kapazitätsbereich liegt normalerweise bei 0.2 bis 6 pF.

Wenn der Rohrkondensator $C_T$ resp. $C_M$ (Fig. 2a) direkt mit dem HF-mäßig heißen Ende der Spule L verbunden ist, treten die weiter oben berechneten hohen Spannungswerte direkt über dem Rohrkondensator auf, so dass dieser entsprechend hochspannungsfest gebaut werden muss.

Es kommt aber auch vor, dass der Rohrkondensator $C_M$ nicht direkt mit dem heißen Ende der Spule L verbunden wird, sondern über einen festen Seriekondensator, um dadurch den Abstimmbereich der Resonanzfrequenz $f_0$ zu ver-kleinern und eine Feinabstimmung zu ermöglichen. In diesem Fall reduziert sich die Spannung über dem Rohrkondensator entsprechend dem kapazitiven Spannungsteiler, und die Problematik der Hochspannungsfestigkeit überträgt sich mehr und mehr auf den zusätzlichen Seriekondensator, der aber weniger kritisch ist, da er einen festen Kapazitätswert besitzt. Dieser Fall tritt jedoch nicht immer auf, sondern vorzugsweise bei der Protonenspektroskopie.

Die Spannungsfestigkeit eines Kondensators ist erstens vom Abstand der Elektroden, zweitens von der Form der Elektroden und z.T. des Dielektrikums, sowie drittens von der Durchschlagsfestigkeit des Dielektrikums abhängig, wobei letzteres Luft, ein Gas, ein Feststoff oder eine Flüssigkeit sein kann.

Im Rahmen der Erfindung wurde festgestellt, dass der oben beschriebene Rohrkondensator normalerweise nicht im zylindrischen Bereich des metallischen Stabes 2 (z.B. die Stelle 6, **Fig. 5**) durchschlägt, wo der Luftspalt am kleinsten ist und man am ehesten einen Durchschlag vermuten würde. Im Gegenteil, der Überschlag erfolgt in einem Bereich 7 um das Stabende 5', wo die Luftstrecken am größten sind. Dies ist auch dann der Fall, wenn dieses Ende möglichst rund ausgebildet ist und keine kantenförmigen Übergänge besitzt, so dass keine zusätzlichen Erhöhungen der elektrischen Feldstärke zu erwarten sind. Eine Erklärung für dieses unerwartete Verhalten ist weiter unten angegeben.

Es besteht somit ein dringendes Bedürfnis nach Rohrkondensatoren mit verbesserten HF-Durchschlagsfestigkeiten.

*3. Der erfindungsgemäße Rohrkondensator*

Der Durchschlag im Bereich 7, Fig. 5, entsteht durch eine lokale Ionisierung der Luft, wodurch ein elektrisch leitendes Plasma entsteht, welches hohe Stromspitzen übertragen kann und dadurch im Bereich des Stabendes 5' sowohl die Oberfläche der Innenelektrode wie auch die Oberfläche der Innenbohrung 41 des dielektrischen Rohres 3 beschädigt.

Experimentelle Untersuchungen haben gezeigt, dass Änderungen an der Form der Abrundung des metallischen Stabes 2 keinen großen Einfluss auf die Durchschlagsfestigkeit haben, sofern die Radien dieser Abrundung nicht zu klein gewählt sind, und sofern die Abrundung keine kantenförmigen Übergänge besitzt. Auch die Form der Außenelektrode 1 und die Wahl des Dielektrikums und des Elektrodenmaterials haben nur einen sekundären Einfluss auf die Durchschlagsfestigkeit.

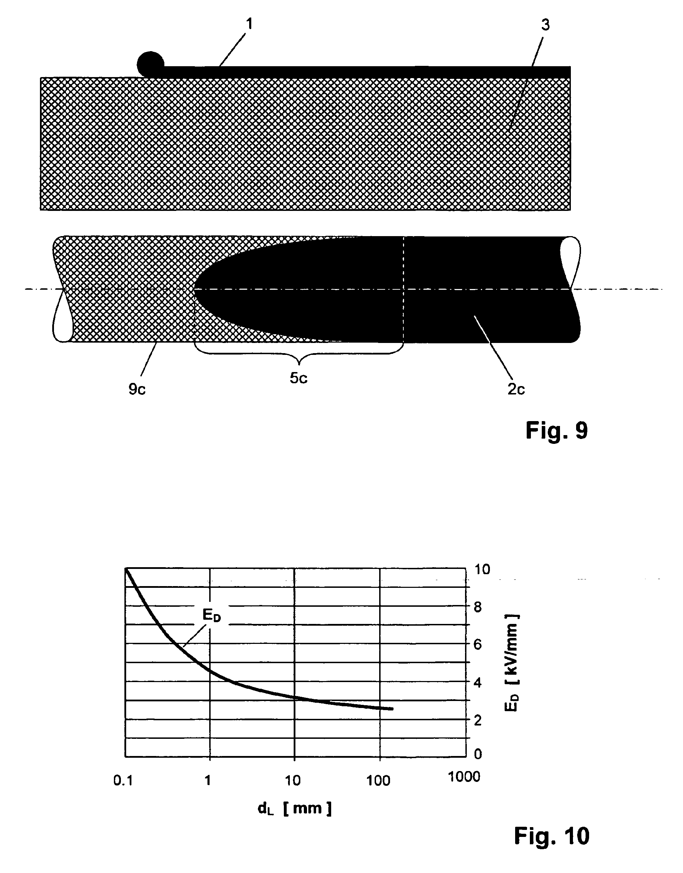

Spannungsversuche haben ferner gezeigt, dass die Durchschläge normalerweise nicht im festen Dielektrikum stattfinden, sondern vorwiegend in der Luft und zwar im Bereich 7 in der Nähe des Stabendes 5'. Eine Erklärung dazu erhält man durch die Kurve der Durchschlagsfeldstärke $E_D$ für Luft in Abhängigkeit des Luftspaltes zwischen zwei planaren Elektroden (**Fig.10**). Daraus entnimmt man, dass die Durchschlagsfeldstärke $E_D$ mit kleiner werdendem Luftspalt zunimmt, d.h. unkritischer wird.

Kritisch und zu Durchschlägen neigend sind demnach jene Luftbereiche zwischen den beiden Elektroden des Rohrkondensators, wo hohe elektrische Feldstärken E auftreten und zugleich größere freie Weglängen $s_L$ entlang den E-Linien vorhanden sind. Das ist beim gerundeten Ende 5' der Innenelektrode der Fall und erklärt somit die Spannungsüberschläge, die gerade dort (Bereich 7, Fig. 5) auftreten.

Im zylindrischen Bereich der Innenelektrode hingegen (z.B. Bereich 6, Fig.5) ist der Luftspalt sehr klein (z.B. < 0.1 mm), und da die im Luftspalt vorhandenen E-Linien senkrecht zur Oberfläche des metallischen Stabes 2 und des dielektrischen Rohrs 3 verlaufen, sind auch die freien Weglängen entlang diesen E-Linien sehr klein. Die Spannungsfestigkeit ist deshalb in diesem Bereich viel größer und erklärt auch, warum dort keine Spannungsüberschläge auftreten.

Da verschiedene dielektrische Materialien zur Verfügung stehen, die wesentlich höhere Durchschlagsfestigkeiten besitzen als Luft, ist es deshalb die Grundidee dieser Erfindung, sämtliche Lufträume, die sich in Bereichen hoher elektrischer Feldstärke befinden, auf ein Minimum zu reduzieren, indem diese Lufträume durch dielektrisches Material hoher Durchschlagsfestigkeit ersetzt werden. Erschwerend kommt dazu, dass die Innenelektrode beweglich bleiben muss, so dass variable Kapazitätswerte möglich sind.

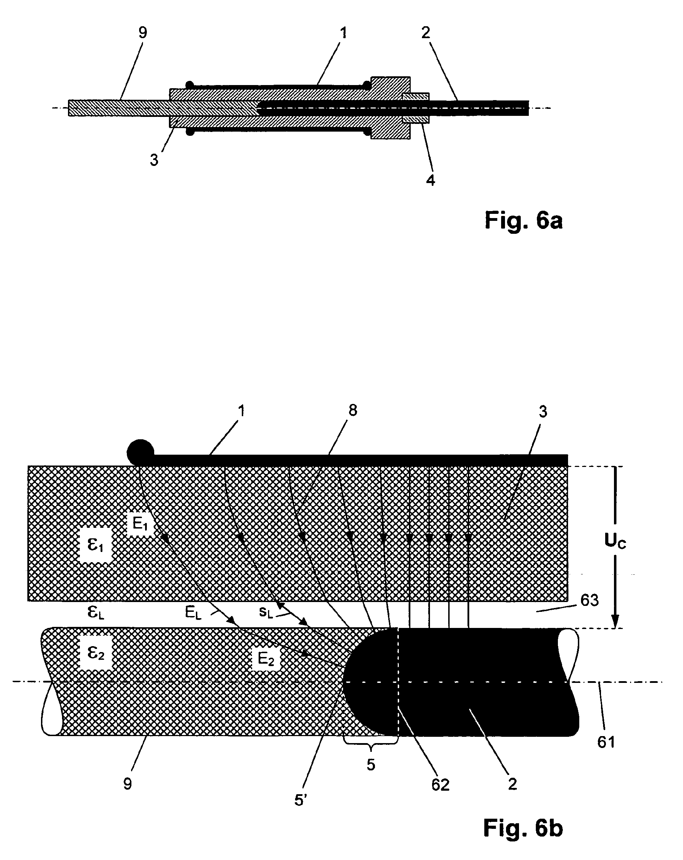

Erfindungsgemäß wird diese Grundidee dadurch verwirklicht, dass der metallischen Stab 2, 2a, 2b der Innenelektrode an seinem in der Innenbohrung 41 befindlichen Ende 5', insbesondere an einem dortigen so genannten Abschlussteil 5, 5a, 5b, 5c, durch einen dielektrischen Stab 9, 9a, 9b, 9c in axialer Richtung verlängert ist, vgl. **Figuren 6a, 6b, 7, 8 und 9**. Bevorzugt ist der dielektrische Stab 9, 9a, 9b, 9c dicht, d.h. ohne Lufteinschlüsse, mit der gesamten Oberfläche dieses Abschlussteils 5, 5a, 5b, 5c. Weiterhin bevorzugt besitzt der dielektrische Stab 9, 9a, 9b, 9d an einem Verbindungsbereich 62 (vgl. Fig. 6b) mit dem metallischen Stab 2, 2a, 2b, 2c, und vorzugsweise auch entlang seiner gesamten Länge, den gleichen Außendurchmesser wie der metallische Stab.

Zudem darf das Abschlussteil 5, 5a, 5b, 5c keine kantenförmigen Übergänge besitzen, insbesondere am Anfang beim Übergang in den zylindrischen Teil der Innenelektrode, und die Radien seiner sämtlichen Abrundungen sollten möglichst groß gewählt werden. Das Abschlussteil 5, 5a, 5b, 5c des metallischen Stabes 2 beginnt dort, wo der metallische Stab 2 im Bereich seines in der Bohrung des dielektrischen Rohres 3 liegenden Endes 5' von der zylinderförmigen Gestalt abweicht (d.h. der Durchmesser sich verkleinert) und erstreckt sich bis zum eigentlichen Ende 5' des metallischen Stabes.

In **Fig. 6b** ist im Querschnitt ein erfindungsgemäßer Rohrkondensator mit einem metallischen Stab 2 dargestellt, der im Wesentlichen eine kreiszylindrische Form hat. Der metallische Stab 2 weist ein halbkugelförmiges Abschlussteil 5 auf. Ein Stab 9 aus dielektrischem Material, der ebenfalls eine im Wesentlichen kreiszylindrische Form aufweist, hat stirnseitig eine halbkugelförmige Vertiefung, in der das Abschlussteil 5 vollflächig anliegt und befestigt ist (beispielsweise durch kleben). Die in Fig. 6b rechte Kante des dielektrischen Stabes 9 fällt mit dem rechten Ende (oder dem "Ansatz") des Abschlussteils 5 zusammen in einem Verbindungsbereich 62, der eine ringförmige Linie um die Innenelektrode (umfassend den metallischen Stab 2 und den dielektrischen Stab 9) bildet. Der metallische Stab 2 ist zusammen mit dem dielektrischen Stab 9 in Fig. 6b nach links und rechts beweglich, um die Kapazität des Rohrkondensators einstellen zu können.

In Fig. 6b sind einige elektrische Feldlinien 8 dargestellt, die sich bei Anliegen einer Spannung $U_C$ zwischen Innenelektrode und Außenelektrode 1 ausbilden. Feldlinienabschnitte $E_1$ im Dielektrikum (mit Dielektrizitätskonstante $\varepsilon_1$) des Rohres 3 und Feldlinienabschnitte $E_2$ im Dielektrikum (mit Dielektrizitätskonstante $\varepsilon_2$) des dielektrischen Stabes 9 sind für die Durchschlagfestigkeit relativ unkritisch. Feldlinienteile $E_L$ im Luftspalt 63 (mit Dielektrizitätskonstante $\varepsilon_L$) hingegen sind wegen der geringen Durchschlagfestigkeit der Luft kritisch. Dabei führen größere freie Weglängen $s_L$ der Feldlinien im Luftspalt 63 zu geringeren Durchschlagfestigkeiten. Durch den erfindungsgemäß vorgesehenen dielektrischen Stab 9 werden jedoch die freien Weglängen $s_L$ im Luftspalt minimiert. Man beachte, dass in Figur 6b weiter links liegende Feldlinien zwar größere freie Weglängen $s_L$ im Luftspalt aufweisen, aber die elektrische Feldstärke nach links hin abnimmt, angedeutet durch den größeren Feldlinienabstand. Die geringere Feldstärke reduziert dann die Durchschlagsgefahr.

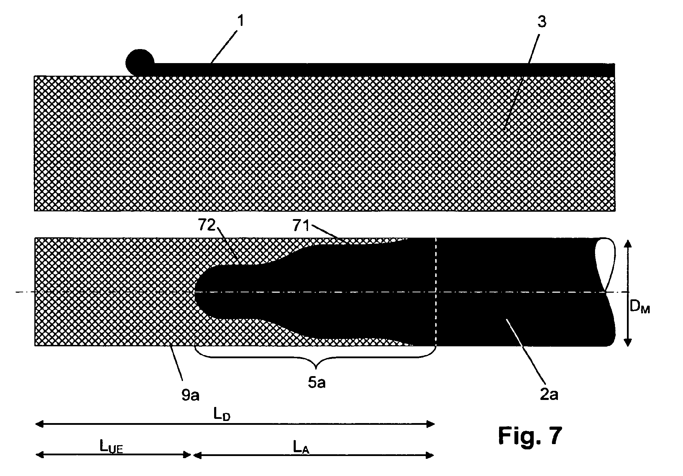

Die Länge des dielektrischen Stabes 9, 9a, 9b, 9c darf beliebig lang gewählt werden, es sollte aber wenigstens gelten $L_D \geq L_A + 1{,}5 \cdot D_M$, mit $L_D$: gesamte axiale Ausdehnung des dielektrischen Stabes; $L_A$: axiale Ausdehnung des Abschlussteils; $D_M$: Durchmesser des metallischen Stabes, vgl. beispielhaft **Fig. 7**. Mit anderen Worten: Die überstehende Länge $L_{UE}$ des dielektrischen Stabes 9, 9a, 9b, 9c beträgt wenigstens das anderthalbfache des Durchmessers $D_M$ des metallischen Stabes. Diese Minimalbedingung verhindert, dass am Ende des dielektrischen Stabes noch große elektrische Feldspitzen entstehen können.

Damit die dielektrische Verlängerung 9a mechanisch stabiler mit dem metallischen Stab 2a der Innenelektrode verbunden werden kann, lässt sich in einer bevorzugten Ausführungsform die Form des Abschlussteils 5a so wählen, dass sie mindestens eine zylinderförmige Stufe enthält (5a, Fig.7). Im Beispiel von Fig. 7 sind zwei zylinderförmige Stufen 71, 72 vorgesehen. Die sanfte Verkleinerung des Außendurchmessers entlang des Abschlussteils 5a hat zudem den großen Vorteil, dass die auftretenden Feldspitzen kleiner sind, als wenn der Abschlussteil näherungsweise halbkugelförmig (Bzz. 5, Fig.6b) ausgebildet ist.

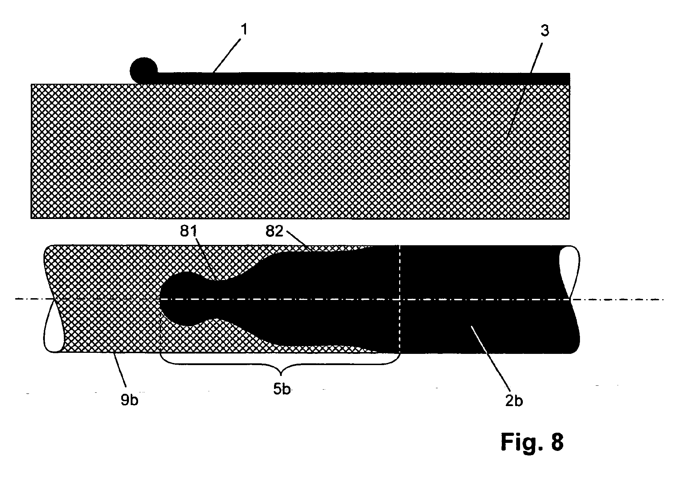

In einer weiteren besonders bevorzugten Ausführungsform enthält die Form des Abschlussteils 5b mindestens eine Einschnürung 81 und vorzugsweise auch noch mindestens eine zylinderförmige Stufe 82 (Fig.8). Die Einschnürung 81 hat den Vorteil, dass die mechanische Verankerung der dielektrischen Verlängerung 9b mit dem metallischen Stab 2b viel stabiler und robuster ist.

In einer weiteren Ausführungsform besitzt der Abschlussteil 5c näherungsweise die Form eines lang gezogenen Rotations-Ellipsoides (Fig.9). Solche Formen führen zu den kleinsten Feldspitzen, haben aber den Nachteil, dass eine zuverlässige und robuste Verankerung der dielektrischen Verlängerung mit dem Abschlussteil nur schwer zu erreichen ist.

Anhand von Feldsimulationsprogrammen lässt sich sehr schön zeigen, wie sich die Felder im Luftspalt zwischen verschiebbarem Stab und Dielektrikum verhalten.

Im folgenden sollen kurz zwei Begriffe erläutert werden:

Axiale Felder oder Feldkomponenten sind solche, die parallel zur Symmetrieachse 61 des Rohrkondensators laufen gemäss Fig. 6b.

Radiale Felder oder Feldkomponenten sind solche, die in jedem Punkt des Raumes zur Symmetrieachse 61 des Rohrkondensators senkrecht stehen.

Am folgenden Beispiel wurden die Felder im Luftspalt berechnet für einen metallischen Stab 2 mit einem elliptischen Abschlussteil (Rotations-Ellipsoid, 5c in Fig. 9), welches dielektrisch fortgeführt ist. Die dielektrische Verlängerung 9c des Stabes 2c hat die gleiche relative Dielektrizitätskonstante wie das Dielektrikum des Rohrs 3, in diesem Fall Teflon mit $\varepsilon_r$ = 2.2. Als Anregung für die Berechnung wurde eine Spannung von 1V genommen, die über dem Kondensator anliegt. Da die Feldlinienbilder von der Spannung unabhängig sind, können alle Feldwerte für den realen Fall, von 1V ausgehend, umskaliert werden.

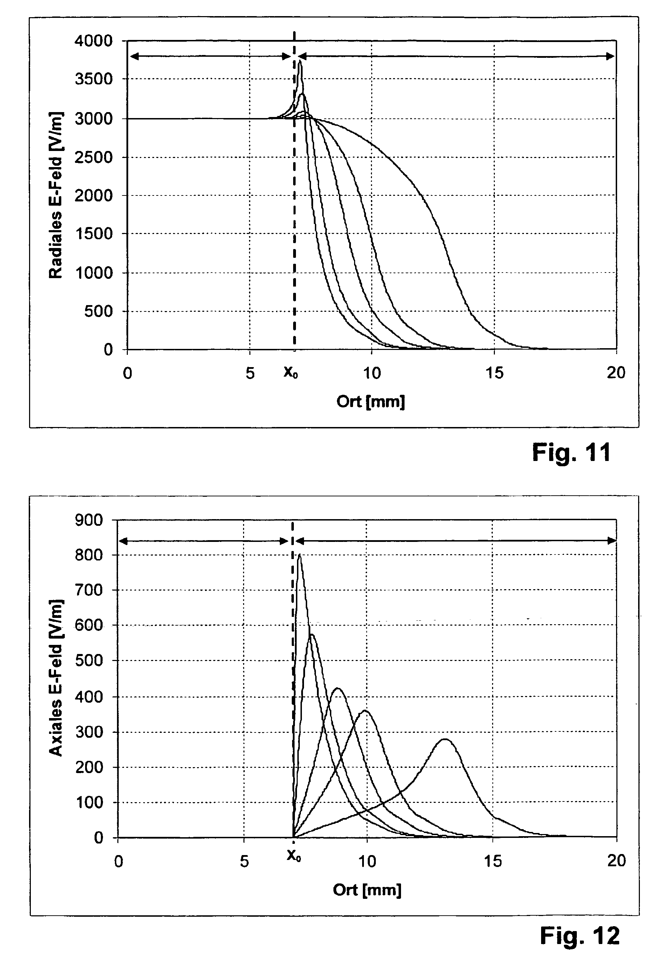

Fig. 11 zeigt die radialen Feldkomponenten als Funktion des Ortes, jeweils für verschiedene Halbachsenverhältnisse der Rotations-Ellipsoide (1:0.5, 1:1, 1:2, 1:3, 1:6 von links nach rechts im rechten Teil des Diagramms). Der Ursprung der Abszisse ist irgendwo im zylindrischen Teil des Stabes (Fig. 9, 2c) gelegt und die radialen Feldkomponenten im Luftspalt zwischen metallischem Stab 2 und dielektrischem Rohr 3 werden bis über das Ende des metallischen Teiles des Stabes hinaus beobachtet. Man sieht, dass im zylindrischen Teil des metallischen Stabes ($0 < x \leq x_0$ mm; in Fig. 11 linke Diagrammhälfte) das Feld konstant 3000 V/m beträgt. An der Stelle $x_0$, wo der metallische Teil des Stabes beginnt mit einem elliptischen Übergang in die dielektrische Verlängerung einzutauchen, ist eine Feldüberhöhung im Luftspalt unvermeidlich. Je nach Geometrie des Stabendes kann diese Überhöhung aber minimiert werden.

Man sieht in Fig. 11, dass das lange Rotations-Ellipsoid mit einem Achsenverhältnis von 1:6 fast keine Feldüberhöhung mehr hat und dass sich das Feld entlang des Luftspaltes kontinuierlich und sanft abbaut ( $x > x_0$ mm, rechte Diagrammhälfte). Dieser dielektrisch verlängerte Stab wird sehr hohe Spannungen halten können, ohne dass es an irgendeiner Stelle zur Funkenbildung kommt. Die maximale Spannungsfestigkeit des Rohrkondensators wird in diesem Falle fast nur durch die Spannungsfestigkeit des Luftspaltes gem. Fig. 10 bestimmt.

Fig. 12 zeigt für die gleiche Geometrie die axiale Feldkomponente, wiederum für verschiedene Halbachsenverhältnisse der Rotations-Ellipsoide (1:0.5, 1:1, 1:2, 1:3, 1:6 von links nach rechts bezüglich der Maxima). Sie ist weniger kritisch und an jeder Stelle im Luftspalt immer deutlich kleiner als die radiale Komponente. Trotzdem sollte sie in der Betrachtung nicht vernachlässigt werden, da sie immer in Richtung der maximalen freien Weglänge für Teilchenlawinen zeigt, also in die Richtung, in der das Zünden am einfachsten ist und wo die Vorteile des dünnen Luftspaltes gem. Fig. 10 nicht mehr zum Tragen kommen.

Praktische Belastungsmessungen an erfindungsgemäß hergestellten Funktionsmustern bestätigen die Theorie: Deutlich größere Spannungen können an dielektrisch verlängerten Rohrkondensatoren gehalten werden, ohne dass es zur Funkenbildung und damit zur Zerstörung des Rohrkondensators kommt.

*4. Bezugszeichenliste*

| | |
|---|---|
| 1 | Außenelektrode |
| 2, 2a, 2b, 2c | metallischer Stab |
| 3 | Rohr aus dielektrischem Material |
| 4 | metallische Kontakthülse |
| 5, 5a, 5b, 5c | Abschlussteil des metallischen Stabes |
| 5' | Ende des metallischen Stabes, das innerhalb der Innenbohrung des Rohres 3 liegt |
| 6 | Stelle im Luftspalt zwischen dielektrischem Rohr 3 und metallischem Stab 2 im zylindrischen Bereich |

| | |
|---|---|
| | des metallischen Stabes 2 |
| 7 | Bereich eines Luftspalts im Bereich des Endes 5' des metallischen Stabes |
| 8 | Feldlinie |
| 9, 9a, 9b, 9c | Stab aus dielektrischem Material |
| 41 | Innenbohrung des Rohres 3 aus dielektrischem Material |
| 61 | Symmetrieachse des Rohrkondensators |
| 62 | Verbindungsbereich |
| 63 | Luftspalt |
| 71, 72 | zylinderförmige Stufe |
| 81 | Einschnürung |
| 82 | zylinderförmige Stufe |

**Patentansprüche**

1. Rohrkondensator mit variabler Kapazität, umfassend ein zylinderförmiges Rohr (3) aus dielektrischem Material, eine metallische Außenelektrode (1), die das zylinderförmige Rohr (3) umgibt, und eine Innenelektrode, die in der Innenbohrung (41) des zylinderförmigen Rohrs (3) axial beweglich ist und in der Innenbohrung (41) anliegt, wobei die Innenelektrode einen metallischen Stab (2; 2a; 2b; 2c) umfasst,
**dadurch gekennzeichnet,**
**dass** der metallische Stab (2; 2a; 2b; 2c) an seinem Ende (5'), das sich in der Innenbohrung (41) des zylinderförmigen Rohres (3) befindet, durch einen Stab (9; 9a; 9b; 9c) aus dielektrischem Material in axialer Richtung verlängert ist.

2. Rohrkondensator nach Anspruch 1, **dadurch gekennzeichnet, dass** der Stab (9; 9a; 9b; 9c) aus dielektrischem Material in einem sich dem metallischen Stab (2; 2a; 2b; 2c) unmittelbar anschließenden Längenbereich, insbesondere über seine gesamte Länge ($L_D$), den gleichen Außendurchmesser besitzt wie der metallische Stab (2; 2a; 2b; 2c).

3. Rohrkondensator nach einem der vorhergehenden Ansprüche, **dadurch gekennzeichnet, dass** der metallische Stab (2; 2a; 2b; 2c) am seinem Ende (5'), das sich in der Innenbohrung (41) des zylinderförmigen Rohres (3) befindet, ein abgerundetes Abschlussteil (5; 5a; 5b; 5c) besitzt, insbesondere derart, dass keine kantenförmigen Übergänge am diesem Ende des metallischen Stabes (2; 2a; 2b; 2c) vorhanden sind.

4. Rohrkondensator nach Anspruch 3, **dadurch gekennzeichnet, dass** die Länge $L_D$ des Stabes (9; 9a; 9b; 9c) aus dielektrischem Material mindestens die Summe aus der axialen Ausdehnung $L_A$ des Abschlussteils (5; 5a; 5b; 5c) und dem 1,5-fachen Durchmesser $D_M$ des metallischen Stabes (2; 2a; 2b; 2c) beträgt.

5. Rohrkondensator nach einem der Ansprüche 3 oder 4, **dadurch gekennzeichnet, dass** das Abschlussteil (5a; 5b) des metallischen Stabes (2a; 2b) mindestens eine zylinderförmige Stufe (71, 72; 82) aufweist.

6. Rohrkondensator nach einem der Ansprüche 3 bis 5, **dadurch gekennzeichnet, dass** das Abschlussteil (5b) des metallischen Stabes mindestens eine Einschnürung (81) aufweist.

7. Rohrkondensator nach einem der Ansprüche 3 bis 6, **dadurch gekennzeichnet, dass** der Stab (9; 9a; 9b; 9c) aus dielektrischem Material mit der gesamten Oberfläche des Abschlussteils (5; 5a; 5b; 5c) dicht, insbesondere ohne Lufteinschlüsse, verbunden ist.

8. Rohrkondensator nach einem der vorhergehenden Ansprüche, **dadurch gekennzeichnet, dass** das dielektrische Material des zylinderförmigen Rohres (3) und das dielektrische Material des Stabes (9; 9a; 9b; 9c) relative Dielektrizitätskonstanten zwischen 1,3 und 5 aufweisen, wobei vorzugsweise sich die relativen Dielektrizitätskonstanten um 1,0 oder weniger unterscheiden, insbesondere wobei die beiden relativen Dielektrizitätskonstanten identisch sind und wobei vorzugsweise das dielektrische Material jeweils Teflon ist.

9. Kernspinresonanz (=NMR)-Probenkopf, umfassend einen Hochfrequenz(=HF)-Resonator und eine Schaltung zum Betrieb des HF-Resonators, **dadurch gekennzeichnet, dass** die Schaltung mindestens einen Rohrkondensator nach einem der vorhergehenden Ansprüche umfasst.

**Claims**

1. Tubular capacitor with variable capacitance, comprising a cylindrical tube (3) of dielectric material, a metallic outer electrode (1) which surrounds the cylindrical tube (3), and an inner electrode which can be axially moved in the inner bore (41) of the cylindrical tube (3) and abuts the inner bore (41), wherein the inner electrode comprises a metallic rod (2; 2a; 2b; 2c), **characterized in that** the metallic rod (2; 2a; 2b; 2c) is axially extended at its end (5') located in the inner bore (41) of the cylindrical tube (3), by means of a rod (9; 9a; 9b; 9c) of dielectric material.

2. Tubular capacitor according to claim 1, **characterized in that**, in a longitudinal region immediately joining the metallic rod (2; 2a; 2b; 2c), the rod (9; 9a; 9b; 9c) of dielectric material has the same outer diameter as the metallic rod (2; 2a; 2b; 2c), in particular, along its entire length ($L_D$).

3. Tubular capacitor according to any one of the preceding claims, **characterized in that** the metallic rod (2; 2a; 2b; 2c) has a rounded end part (5; 5a; 5b; 5c) at its end (5') located in the inner bore (41) of the cylindrical tube (3), in particular, such that there are no sharp transitions at this end of the metallic rod (2; 2a; 2b; 2c).

4. Tubular capacitor according to claim 3, **characterized in that** the length $L_D$ of the rod (9; 9a; 9b; 9c) of dielectric material amounts to at least the sum of the axial extension $L_A$ of the end part (5; 5a; 5b; 5c) and 1.5 times the diameter $D_M$ of the metallic rod (2; 2a; 2b; 2c).

5. Tubular capacitor according to one of the claims 3 or 4, **characterized in that** the end part (5a; 5b) of the metallic rod (2a; 2b) has at least one cylindrical step (71, 72; 82).

6. Tubular capacitor according to any one of the claims 3 through 5, **characterized in that** the end part (5b) of the metallic rod has at least one constriction (81).

7. Tubular capacitor according to any one of the claims 3 through 6, **characterized in that** the rod (9; 9a; 9b; 9c) of dielectric material is connected to the overall surface of the end part (5; 5a; 5b; 5c) in a sealing manner, in particular, without air inclusions.

8. Tubular capacitor according to any one of the preceding claims, **characterized in that** the dielectric material of the cylindrical tube (3) and the dielectric material of the rod (9; 9a; 9b; 9c) have relative dielectric constants of between 1.3 and 5, wherein the relative dielectric constants preferably differ by 1.0 or less, in particular, wherein the two relative dielectric constants are equal and wherein the dielectric material is preferably Teflon in each case.

9. Nuclear magnetic resonance (NMR) probe head, comprising a radio frequency (RF) resonator and a circuit for operating the RF resonator, **characterized in that** the circuit comprises at least one tubular capacitor according to any one of the preceding claims.

**Revendications**

1. Condensateur tubulaire de capacité variable, comprenant un tube cylindrique (3) en matériau diélectrique, une électrode externe métallique (1) qui entoure le tube cylindrique (3) et une électrode interne qui est mobile axialement dans l'alésage intérieur (41) du tube cylindrique (3) et qui est ajustée dans l'alésage intérieur (41),
l'électrode interne comprenant une tige métallique (2 ; 2a ; 2b ; 2c),
**caractérisé en ce que**
la tige métallique (2 ; 2a ; 2b ; 2c) est prolongée en direction axiale, à son extrémité (5') qui se trouve dans l'alésage intérieur (41) du tube cylindrique (3), par une tige (9 ; 9a ; 9b ; 9c) en matériau diélectrique.

2. Condensateur tubulaire selon la revendication 1, **caractérisé en ce que** la tige (9 ; 9a ; 9b ; 9c) en matériau diélectrique possède, dans une portion longitudinale qui fait directement suite à la tige métallique (2 ; 2a ; 2b ; 2c), en particulier sur toute sa longueur ($L_D$), le même diamètre extérieur que la tige métallique (2 ; 2a ; 2b ; 2c).

3. Condensateur tubulaire selon l'une des revendications précédentes, **caractérisé en ce que** la tige métallique (2 ; 2a ; 2b ; 2c) possède, à son extrémité (5') qui se trouve dans l'alésage intérieur (41) du tube cylindrique (3), une partie terminale arrondie (5 ; 5a ; 5b ; 5c), en particulier telle qu'il n'existe pas de transitions en forme d'arête à cette extrémité de la tige métallique (2 ; 2a ; 2b ; 2c).

**4.** Condensateur tubulaire selon la revendication 3, **caractérisé en ce que** la longueur $L_D$ de la tige (9 ; 9a ; 9b ; 9c) en matériau diélectrique est au moins égale à la somme de l'extension axiale $L_A$ de la partie terminale (5 ; 5a ; 5b ; 5c) et de 1,5 fois le diamètre $D_M$ de la tige métallique (2 ; 2a ; 2b ; 2c).

**5.** Condensateur tubulaire selon l'une des revendications 3 ou 4, **caractérisé en ce que** la partie terminale (5a ; 5b) de la tige métallique (2a ; 2b) présente au moins un gradin cylindrique (71, 72 ; 82).

**6.** Condensateur tubulaire selon l'une des revendications 3 à 5, **caractérisé en ce que** la partie terminale (5b) de la tige métallique présente au moins un resserrement (81).

**7.** Condensateur tubulaire selon l'une des revendications 3 à 6, **caractérisé en ce que** la tige (9 ; 9a ; 9b ; 9c) en matériau diélectrique est reliée de manière étanche, en particulier sans inclusions d'air, à toute la surface de la partie terminale (5 ; 5a ; 5b ; 5c).

**8.** Condensateur tubulaire selon l'une des revendications précédentes, **caractérisé en ce que** le matériau diélectrique du tube cylindrique (3) et le matériau diélectrique de la tige (9 ; 9a ; 9b ; 9c) présentent des constantes diélectriques relatives comprises entre 1,3 et 5, les constantes diélectriques relatives différant l'une de l'autre de préférence de 1,0 ou moins, en particulier les deux constantes diélectriques relatives étant identiques et le matériau diélectrique étant de préférence dans chaque cas du téflon.

**9.** Tête de mesure pour la résonance magnétique nucléaire (= RMN), comprenant un résonateur à haute fréquence (HF) et un circuit pour exploiter le résonateur HF, **caractérisée en ce que** le circuit comprend au moins un condensateur tubulaire selon l'une des revendications précédentes.

**Fig. 1**

**A**     **B**

21  50 Ω  $C_M$  L $R_L$ $C_T$

**Fig. 2a**

50 Ω **A** $U_0/2$ (-6dB)

$U_0$

22  50 Ω  23

**Fig. 2b**

Fig. 3a

Fig. 3b

Fig. 3c

Fig. 3d

## Fig. 4

Stand der Technik

## Fig. 5

Stand der Technik

**Fig. 6a**

**Fig. 6b**

Fig. 7

**Fig. 8**

**Fig. 9**

**Fig. 10**

**Fig. 11**

**Fig. 12**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

• EP 1329916 A

**In der Beschreibung aufgeführte Nicht-Patentliteratur**

• Avance - The Pulse Of Innovation. Firma Bruker Biospin AG, April 2004